# EUROPÄISCHE PATENTSCHRIFT

(11) **EP 0 450 125 B1**
(45) Veröffentlichungstag und Bekanntmachung des Hinweises auf die Patenterteilung: **26.10.1994**
(21) Anmeldenummer: 90106584.7
(22) Anmeldetag: 06.04.1990
(51) Int. Cl.: C23C 16/34

(54) **Verfahren zur Herstellung von mikrokristallin kubischen Bornitridschichten**
Process of making microcrystalline cubic boron nitride coatings
Procédé de fabrication de couches en nitrure de bore cubique microcristallin

(43) Veröffentlichungstag der Anmeldung: 09.10.1991
(73) Patentinhaber: SIEMENS AKTIENGESELLSCHAFT, 80333 München (DE)
(72) Erfinder: Treichel, Helmut, D-8900 Augsburg (DE); Spindler, Oswald, D-8011 Vaterstetten (DE); Braun, Rainer, D-8000 München 82 (DE); Neureither, Bernhard, D-8000 München 83 (DE); Kruck, Thomas, D-5042 Erftstadt 18 (DE)

(56) Entgegenhaltungen:
- US-A- 4 440 108
- JOURNAL OF THE ELECTROCHEMICAL SOCIETY, Band 129, Nr. 11, November 1982, Seite2636, Manchester, US; W. SCHMOLLA et al.: "Low temperature double-plasmaprocess for BN films on semiconductors"
- PATENT ABSTRACTS OF JAPAN, Band 10, Nr. 355, 29. November 1986; & JP-A-61 153 279
- PATENT ABSTRACTS OF JAPAN, Band 13, Nr. 339 (C-624)[3687], 31. Juli 1989; & JP-A-1 116 078
- JOURNAL OF VACUUM SCIENCE & TECHNOLOGY A, Band 3, Nr.6, November-Dezember 1985, Seiten 2141-2146, New York, US; W. HALVERSON et al.: "Effects of charge neutralization on ion-beam-deposited boron nitride films"
- SOLID-STATE ELECTRONICS, Band 26, Nr. 931, 1983, Seiten 931-939, GB; W.SCHMOLLA et al.: "Amorphous BN films produced in a double-plasma reactor forsemiconductor applications"
- PATENT ABSTRACTS OF JAPAN, Band 10, Nr. 350, 25. Dezember 1984; & JP-A-61 149 478

## Beschreibung

Die Erfindung betrifft ein Verfahren zur Herstellung einer mikrokristallin kubischen Bornitrid-Schicht durch chemische Gasphasenabscheidung in einem elektromagnetischen Wechselfeld (PECVD-Verfahren).

Bornitrid-Schichten sind in verschiedenen technischen Gebieten von großem Interesse:

### 1) Als Isolationsschicht in integrierten Schaltungen.

Für Intermetallisolations- und Endpassivierungsschichten für höchstintegrierte Halbleiterschaltungen werden dielektrische Schichten mit kleiner Dielektritätskonstanten εᵣ, guten Isolations- und Sperreigenschaften und hoher Durchbruchfestigkeit benötigt, die außerdem eine möglichst konforme Kantenbedeckung aufweisen und nicht hygroskopisch sind. Bornitrid-Schichten haben sich als geeignet erwiesen, insbesondere besitzen sie sowohl in amorpher als auch in polykristalliner Form eine genügend kleine Dielektrizitätskonstante.

Aus dem Artikeln vom W. Schmolla und H. Hartnagel in Solid State Electronics 26 Nr. 10, Seiten 931 bis 939 geht hervor, daß für die Herstellung von kristallinen Bornitridschichten relativ hohe Temperaturen erforderlich sind, und daß bei kubisch kristallinem Bornitrid aufgrund der größeren Energielücke bessere Isolationseigenschaften als bei andere kristallinen Formen zu erwarten sind.

Die bekannten Verfahren zur Herstellung von kubischem Bornitrid beruhen auf einem mehrstufigen Prozeß, wobei zunächst Bornitrid in anderer kristalliner Form, meist in hexogenaler oder rhombohedraler Phase, erzeugt wird und dieses dann bei hoher Temperatur und hohem Druck in die kubische Phase übergeführt wird (siehe beispielsweise EPA 0 216 932). Meist werden schon für die Herstellung der rhombohedralen oder hexogonalen Phase Temperaturen über 750°C benötigt; dadurch sind diese Prozesse zur Herstellung von Intermetallisolations-und Endpassivierungsschichten für höchstintegrierte Halbleiterschaltungen nicht mehr einsetzbar. Auch das in dem Artikel von A. Chayahara et al. in Appl. Surface Science 33/34 (1988) S. 561-566 vorgeschlagene Verfahren zur Herstellung von kubischem Bornitrid unter Verwendung B₂H₆ und Stickstoff in einem PECVD-Verfahren ist für eine fertigungsgemäße Anwendung nicht geeignet, da es eine Abscheiderate von weniger als 6nm/min aufweist, während typische Schichtdicken von einigen 100 nm zur Isolation benötigt werden. Ein weiterer Nachteil ist der Einsatz der sehr gefährlichen gasförmigen Ausgangssubstanz B₂H₆.

### 2) Für Maskenmembranen in der Röntgenlithographie:

Für die Fertigung von sogenannten ULSI-Bauelementen mit Strukturgrößen unterhalb von 0,5 µm ist der Einsatz der Röntgenlithographie notwendig. Eine Röntgenmaske erfordert eine dünne Membran, die hochdurchlässig für weiche Röntgenstrahlen und stabil in ihren Dimensionen während des Herstellungsprozesses und während der Benutzung bei der Bauelementherstellung ist. Wie dem Artikel W. Johnson et al. in Journal of Vacuum Science and Technology B5, Januar 1987, Seite 257 bis 261 zu entnehmen ist, ist amorphes Bornitrid als Maskenmembran im wesentlichen gut geeignet; es kann beispielsweise mit dem in dem bereits erwähnten Artikel von Schmolla und Hartnagel beschriebenen Verfahren hergestellt werden.

Es treten jedoch folgende Nachteile auf: Die entstehenden Bornitrid-Schichten verändern an Luft ihre Oberfläche und Struktur, beispielsweise durch Borsäurekristallwachstum. Die damit verbundene reduzierte Transmission der Schichten erschwert die optische Justierung der Maske beim Einsatz bei der Bauelementeherstellung. Lokale Änderungen von mechanischen Spannungen in der Bornitrid-Schicht können eine Verzerrung der Maske verursachen, die zu nicht mehr tolerierbaren Justierungenauigkeiten führt. Ein weiterer Nachteil ist der komplizierte Anlagenaufbau und die Gefährlichkeit der Ausgangssubstanz beim Herstellungsverfahren.

### 3) Zur Hartstoffbeschichtung

Kubisches Bornitrid wird hauptsächlich zur Herstellung von Schleif- und Schneidescheiben und zur Bearbeitung von gehärteten Stählen, Werkzeugstählen, Superlegierungen und Chromnickelstählen verwendet. Seine Härte bleibt dabei bis ca. 600°C erhalten, während die Härte von z.B. Wolframcarbid bereits bei ca. 300 - 400°C erheblich abnimmt (siehe z. B. M. Rand, J. Roberts in Journal Electrochem. Soc. 115, 1968, Seite 423). Es wird meist aus der hexagonalen Phase des Bornitrid bei Temperaturen über 1500°C und einem Druck von über 80 kbar hergestellt. Nachteilig bei diesem Verfahren sind vor allem die Notwendigkeit von mindestens zwei Verfahrensstufen und die hohen Temperaturen, welche die Struktur des zu härtenden Werkstückes verändern.

Aufgabe der vorliegenden Erfindung ist es daher, ein Verfahren anzugeben, das die Herstellung von kubisch kristallinen Bornitridschichten bei deutlich niedrigeren Temperaturen, insbesondere unter 500°C, in einfacher Weise ermöglicht. Das Verfahren soll einstufig ablaufen und weder gefährliche Ausgangssubstanzen noch einen komplizierten Anlagenaufbau benötigen. Die damit hergestellten kubischen Bornitrid-Schichten sollen die für die genannten Anwendungen erforderlichen Eigenschaften besitzen, insbesondere eine Dielekrizitätskonstante εᵣ< 4 für den Einsatz als Intermetalldielektrikum, eine hohe Durchlässigkeit für weiche Röntgenstrahlung für den Einsatz in der Röntgenlithographie und eine hohe Vickers-Härte für den Einsatz in der Hartstoffbeschichtung.

Diese Aufgabe wird durch ein Verfahren gemäß dem Patentanpruch 1 gelöst.

Erfindungsgemäß werden Ausgangssubstanzen verwendet, die sowohl Bor als auch Stickstoff bereits in einem Molekül enthalten, und vorzugsweise zusammen mit gasförmigem Stickstoff oder Ammoniak in einer HohlKathode angeregt und in einem elektromagnetischen Wechselfeld mit thermischer Unterstützung zersetzt werden (PECVD-Verfahren). Dabei kann das B:N-Verhältnis der abzuscheidenden Schichten und ihre Struktur in der Nahordnung sowohl durch geeignete Wahl der Ausgangssubstanz, durch Modifikation eines Restes R im Molekül der Ausgangssubstanz als auch durch Variation der Parameter des PECVD-Prozesses geändert werden.

Weitere Ausgestaltungen und Weiterbildungen der Erfindung gehen aus den Unteransprüchen und der nachfolgend anhand eines Ausführungsbeispiels gegebenen Beschreibung hervor.

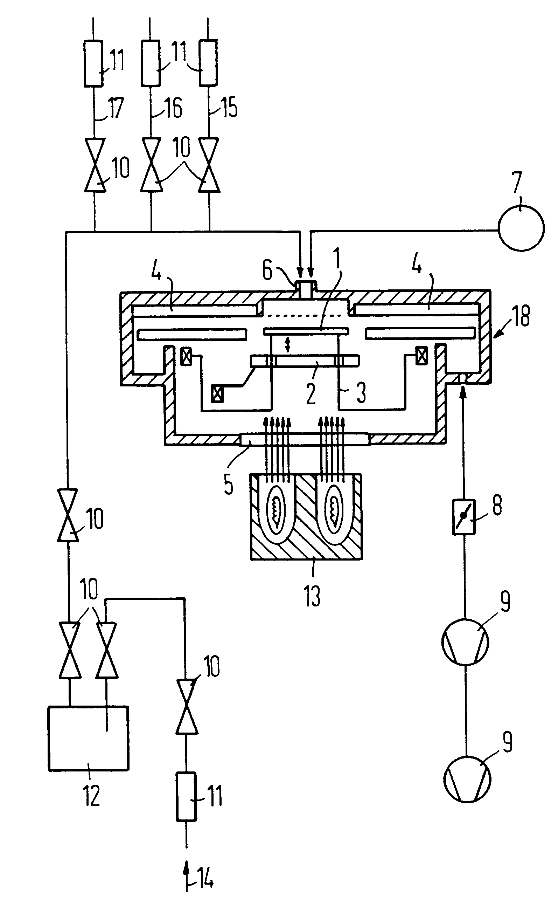

Die Figur zeigt in schematischer Darstellung eine Anlage zur chemischen Dampfabscheidung in einem elektromagnetischem Wechselfeld (PECVD), welche zur Durchführung des erfindungsgemäßen Verfahrens bevorzugt eingesetzt wird. In der Reaktorkammer 18 ist eine zu bearbeitende Halbleiterscheibe 1 auf einem Halbleiterscheibenlift 3 zwischen dem Gaseinlaßbereich 6 und dem Suszeptor 2 angeordnet. Die Bewegung des Halbleiterscheibenliftes 3 ist mit einem Doppelpfeil angedeutet, hierdurch wird der Elektrodenabstand eingestellt. Zur Evakuierung der Reaktorkammer 18 sind zwei Vakuumpumpen 9 vorgesehen, die über ein Butterflyventil 8 angeschlossen sind. Zur Erzeugung des elektromagnetischen Wechselfeldes wird ein RF-Generator eingesetzt, wobei einzelne Bereiche der Reaktorkammer 18 durch Isolatoren 4 abgeschirmt sind. Die bevorzugt flüssige Ausgangssubstanz wird in einem Verdampfergefäß (Bubbler) 12 bereitgestellt, in das als Trägergas Helium oder Stickstoff zugeführt wird. Zur Regulierung des Stickstoffanteils sind weitere Gaszuleitungen 15, 16, 17 für N₂, NH₃ o. ä. vorgesehen. Alle Gaszuleitungen sind mit Durchflußmengenreglern 11 und Pneumatikventilen 10 versehen. Zur Einstellung der Abscheidetemperatur in der Reaktorkammer 18 sind Lampen bzw. ein Reflektormodul 13 vorgesehen, das die in der Reaktorkammer 18 befindliche Anordnung durch ein Quarzfenster 5 bestrahlt. Die Anregung der Ausgangssubstanz und des evtl. zugegebenen N₂- oder NH₃-Gases geschieht im Bereich des Gaseinlasses 6 induktiv oder kapazitiv, beispielsweise in einer Hohlkathode.

Die Aufbringung der Bornitrid-Schicht erfolgt im Temperaturbereich von 200 - 450°C bei einem Druck von 1 - 100 mbar (0,1-10kPa) in der dargestellten PECVD-Anlage. Es wird bevorzugt eine flüssige oder feste Ausgangssubstanz mit einer Verdampfertemperatur im Bereich von 25 bis 120°C verwendet, welche mittels des Trägergases, üblicherweise Helium oder Stickstoff, oder durch Einsaugen in die Prozeßkammer 18 der Anlage eingebracht wird. Die Anregung muß dabei so erfolgen, daß sich die Ausgangssubstanz nicht dabei zersetzt. Dazu eignet sich insbesondere eine Hohlkathodenanregung im Gaseinlaßbereich 6.

Zusätzlich können stickstoffhaltige Prozeßgase wie beispielsweise Stickstoff oder Ammoniak in die Prozeßkammer eingeleitet werden und zusammen mit der Ausgangssubstanz angeregt werden. Durch Auswahl einer geeigneten bor- und stickstoffhaltigen Ausgangssubstanz oder einer Mischung solcher Ausgangssubstanzen und der Prozeßparameter können gezielt Bornitrid-Schichten mit den gewünschten Eigenschaften erzeugt werden; beispielsweise wird die Dielektrizitätskonstante εᵣ über das Verhältnis von Bor zu Stickstoff in der abgeschiedenen Schicht gesteuert, welches wiederum von den genannten Größen abhängt. Die Prozeßparameter für den PECVD-Prozeß liegen dabei in den in der folgenden Tabelle angegebenen Bereichen:

| | |
|---|---|
| Abscheidetemperatur | 200-450 °C |
| Prozeßdruck | 1-100 mbar (0,1-10kPa) |
| RF-Leistung | 100-800 W |
| Eletrodenabstand | 0,3-1,5 cm |
| Trägergasfluß | 0-600 sccm N₂ bzw. He |
| N₂- bzw. NH₃-Fluß | 0-500 sccm |
| Verdampfertemperatur | 25-120 °C |

Als Ausgangssubstanzen kommen insbesondere folgende in Betracht: 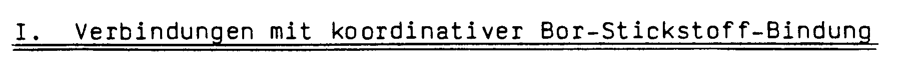
1. Boran-Ammoniak-Addukt:
   H₃B←NH₃
2. Addukte von Boran an Amine:
   H₃B←NHₙR₃₋ₙ mit R = Alkyl, Aryl
   z.B. H₃B←NH(CH₃)₂
3. Addukte von Alkylboranen an Ammoniak:
   HₙR₃₋ₙB←NH₃ mit R = Alkyl, Aryl
   z.B. H(CH₃) ₂B←NH₃
4. Addukte von Organylboranen an Amine:
   HₙR₃₋ₙB←NHₘR₃₋ₘ mit R = Alkyl, Aryl
   z.B. H(CH₃)₂B←NH(CH₃)₂
5. Addukte von Halogenboranen an Amine bzw. Ammoniak:
   HₙX₃₋ₙB←NHₘR₃₋ₘ mit R = H, Alkyl, Aryl; X = F, Cl, Br, I
   z.B. HCL₂B←NH(CH₃)₂
6. Addukte von Alkylhalogenboranen an Amine bzw. Ammoniak:
   XₙR₃₋ₙB←NHₘR₃₋ₘ mit R = H, Alkyl, Aryl; X = F, Cl, Br, I
   z.B. Cl(CH₃)₂B←NH(CH₃)₂
7. Addukte von Borhalogeniden, Organylborhalogeniden und Hydrogenborhalogeniden an Pyridin(-derivate):
   **X**_{**n**}**R**_{**3-n**}**B←NC₅H**_{**5-m**}**R'**_{**m**} mit R, R' = H, Alkyl, Aryl;
   X = F, Cl, Br, I
   z.B. **Cl(CH₃)₂B←NC₅H₆**
8. Addukte von Borhalogeniden, Organylborhalogeniden und Hydrogenborhalogeniden an Nitrile :
   **X**_{**n**}**R**_{**3-n**}**B←NCR'** mit R, R' = H, Alkyl, Aryl;
   X = F, Cl, Br, I
   z.B. **Br(CH₃)₂B←NC(C₂H₅)**

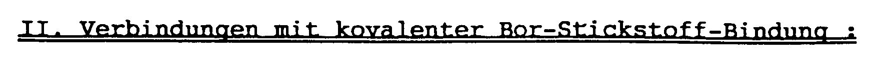

1. (Organyl-)amino-(organyl-)borane :
   **H**_{**n**}**R**_{**2-n**}**BNH**_{**m**}**R'**_{**2-m**} mit R, R' = Alkyl, Aryl
   z.B. **HCH₃BNHC₂H₅**
2. (Organyl-)amino-(organyl-)halogenborane :
   **H**_{**n**}**R**_{**2-n**}**NBR'**_{**m**}**X**_{**2-m**} mit R, R' = Alkyl, Aryl
   X = F, Cl, Br, I
   z.B. **HCH₃NBC₂H₅Cl**
3. Borazine und Borazinderivate :
   a) **B₃N₃R₆** mit R = H, NH₂
      z.B. 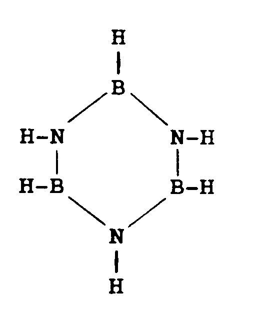
   b) B-Halogenborazine :
      **B₃N₃H₃X₃** mit X = F, Cl, Br, I
      z.B. 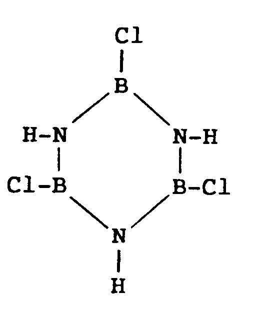
   c) B-Triorganylborazine :
      **B₃N₃H₃R₃** mit R = Alkyl, Aryl
      z.B. 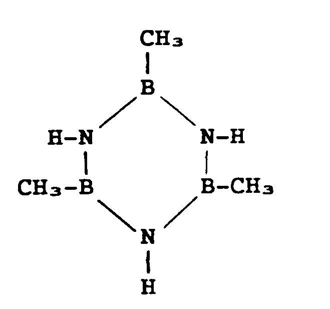
   d) N-Triorganylborazine :
      **B₃N₃H₃R₃** mit R = Alkyl, Aryl
      z.B. 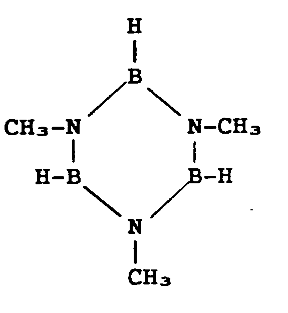
   e) B,N-Hexaorganylderivate :
      **B₃N₃R₆** mit R = Alkyl, Aryl
      z.B. 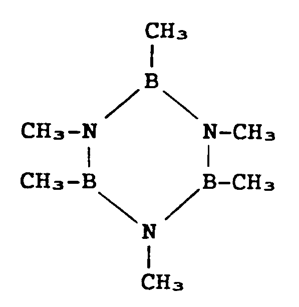
3. **B₂N₂R₆** mit R = H, F, Cl, Alkyl, Aryl, NH₂ (B)
   z.B. 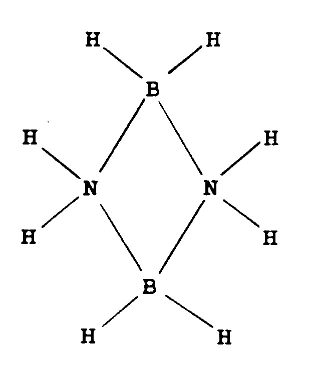
4. 1,2,3,4-Tetraorganyl-1,3-diaza-2,4-diboracyclobutan :
   **B₂N₂R₄** mit R = H, F, Cl, Alkyl, Aryl, NH₂ (B)
   z.B. 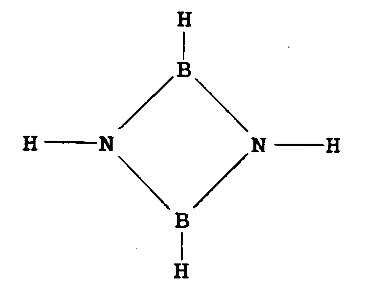
5. 1,2,3,4,5,6,7,8-Octaorganyl-1,3,5,7-tetraaza-2,3,6,8-tetraboracyclooctan :
   **B₄N₄R₈** mit R = H, Alkyl, Aryl, NH₂ (B)
   z.B. 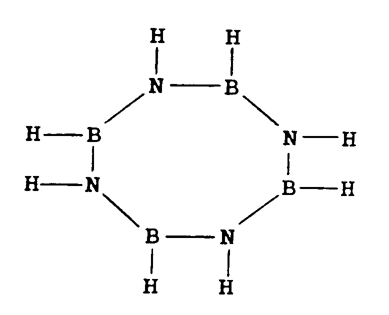
6. 1,3,5,7-Tetraorganyl-2,4,6,8-tetrahalogen-1,3,5,7-tetraaza-2,4,6,8-tetraboracyclooctan :
   **B₄N₄R₄X₄** mit R = H, Alkyl, Aryl, NH₂ (B) X = F, Cl, Br, I
   z.B. 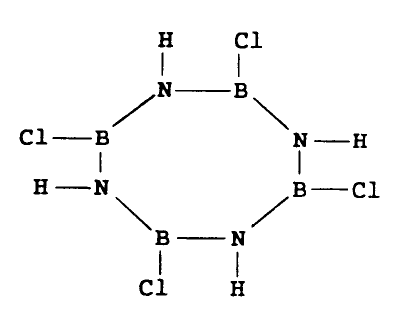
7. 2,3,4,6,7,8-Hexaorganyl-1,3,5,7-tetraaza-2,4,6,8-tetraborabicyclo(3,3,0)octan :
   **B₄N₄R₆** mit R = H, Alkyl, Aryl, NH₂ (B)
   z.B. 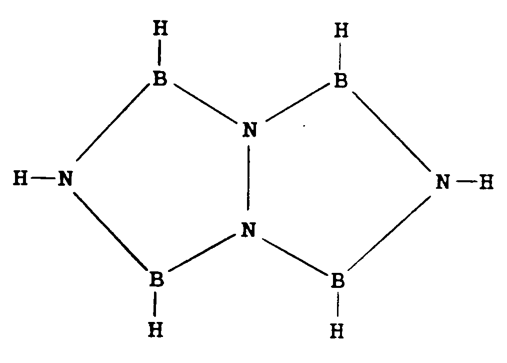
8. 1,2,-Diorganyl-1,2-azaborolane :
   **BNC₃H₆R₂** mit R = H, Alkyl, Aryl, NH₂ (B)
   z.B. 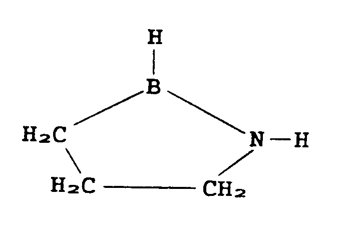
9. 1,2-Diorganyl-1,2,azaborinane :
   **BNC₄H₈R₂** mit R = H, Alkyl, Aryl, NH₂ (B)
   z.B. 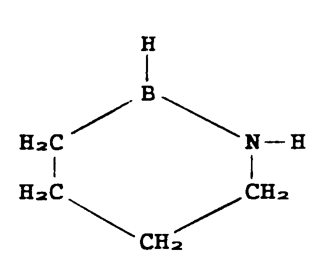
10. 1-Bora-5-azabicyclo(3,3,0)octan :
   **BNC₆H₁₂** 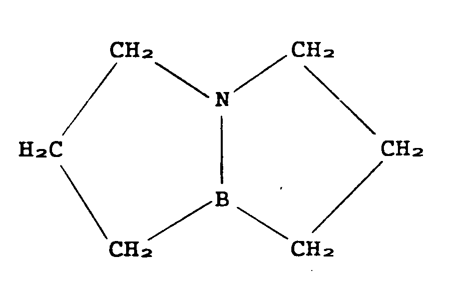
11. 1-Bora-6-azabicyclo(4,4,0)decan :
   **BN(CH₂)₈**

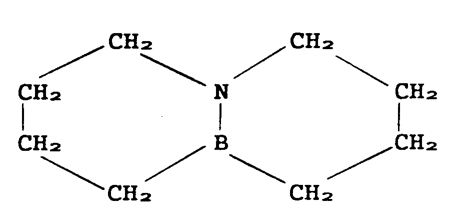

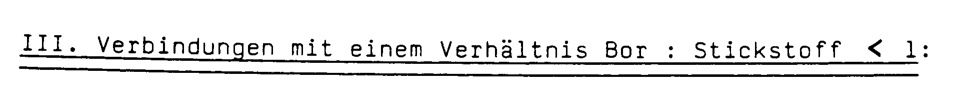

1. Diaminoborane :
   RB(NR'₂)₂ mit R,R' = H, Alkyl, Aryl, NH₂
   z.B. **CH₃B(N(C₂H₅)₂)₂**
2. Triaminoborane :
   **B(NR ₂)₃** mit R = H, Alkyl, Aryl, NH₂
   z.B. **B(N(C₂H₅)₂)₃**
3. B-Aminoborazine :
   **B₃N₃(NR₂)₃R'₃** mit R, R' = H, Alkyl, Aryl, NH₂ (B)
   z.B.

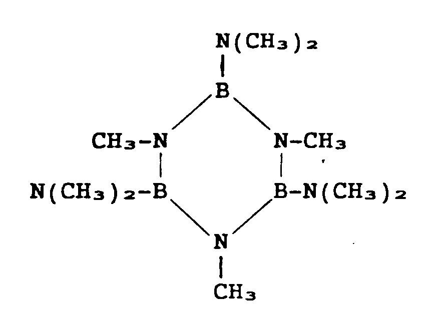

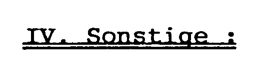

1. **B₃N₃H₆R₆** mit R = H, Alkyl, Aryl, NH₂
   z.B.

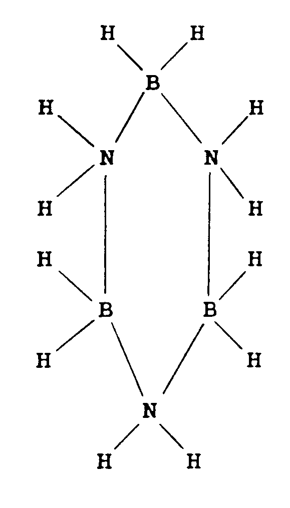

## Patentansprüche

1. Verfahren zur Herstellung einer mikrokristallin kubischen Bornitrid-Schicht durch chemische Gasphasenabscheidung in einem elektromagnetischen Wechselfeld bei einer Temperatur im Bereich von 200 bis 450°C unter Verwendung einer angeregten Ausgangssubstanz, die Bor und Stickstoff in einem Molekül enthält, wobei eine induktive oder kapazitive Anregung mindestens der Ausgangssubstanz in einer Hohlkathode derart erfolgt, daß die Ausgangssubstanz erst im elektromagnetischen Wechselfeld mit thermischer Unterstützung zersetzt wird.

2. Verfahren nach Anspruch 1, **gekennzeichnet** durch eine Verbindung mit koordinativer Bor-Stickstoff-Bindung als Ausgangssubstanz.

3. Verfahren nach Anspruch 1, **gekennzeichnet** durch eine Verbindung mit kovalenter Bor-Stickstoff-Bindung als Ausgangssubstanz.

4. Verfahren nach einem der Ansprüche 1 bis 3, **gekennzeichnet** durch eine Verbindung mit einem Verhältnis Bor : Stickstoff < 1 als Ausgangssubstanz.

5. Verfahren nach einem der Ansprüche 1 bis 4, **dadurch gekennzeichnet,** daß die Ausgangssubstanz mindestens eine Alkyl-, Aryl-, NH₂-Gruppe, Wasserstoff und/oder ein Halogen enthält.

6. Verfahren nach Anspruch 1, **gekennzeichnet** durch die Verwendung von B₃N₃H₆ (Borazin) als Ausgangssubstanz.

7. Verfahren nach einem der Ansprüche 1 bis 6, **dadurch gekennzeichnet,** daß als Ausgangssubstanz eine Mischung von Verbindungen, die Bor und Stickstoff im Molekül enthalten, verwendet wird.

8. Verfahren nach einem der Ansprüche 1 bis 7, **gekennzeichnet** durch eine Zugabe von Ammoniak oder Stickstoff.

9. Verfahren nach einem der Ansprüche 1 bis 8, **gekennzeichnet** durch die Auswahl der Prozeßparameter innerhalb folgender Bereiche:
| | |
|---|---|
| Abscheidetemperatur | 200 - 450°C |
| Prozeßdruck | 1 - 100 mbar (0,1-10kPa) |
| RF-Leistung | 100 - 800 W |
| Elektrodenabstand | 0,3 - 1,5 cm |
| Trägergasfluß | 0 - 600 sccm N₂ bzw. He |
| N₂- bzw. NH₃-Fluß | 0 - 500 sccm |
| Verdampfertemperatur | 25 - 120°C. |

10. Verfahren nach einem der Ansprüche 1 bis 9, **dadurch gekennzeichnet,** daß mechanische, elektrische oder chemische Eigenschaften der abgeschiedenen Bornitrid-Schicht durch Auswahl der Ausgangssubstanz und/oder geeigneter Prozeßparameter eingestellt werden.

## Claims

1. Method for manufacturing a microcrystalline cubic boron nitride layer by chemical vapour deposition in an electromagnetic alternating field at a temperature in the range from 200 to 450°C and using an excited starting material which contains boron and nitrogen in one molecule, an inductive or capacitive excitation of at least the starting material in a hollow cathode being effected in such a way that the starting material is decomposed only in the electromagnetic alternating field with thermal assistance.

2. Method according to Claim 1, characterized by a compound with a coordinative boron-nitrogen bond as the starting material.

3. Method according to Claim 1, characterized by a compound with a covalent boron-nitrogen bond as the starting material.

4. Method according to any one of Claims 1 to 3, characterized by a compound having a ratio of boron: nitrogen < 1 as the starting material.

5. Method according to any one of Claims 1 to 4, characterized in that the starting material contains at least one alkyl, aryl, NH₂ group, hydrogen and/or a halogen.

6. Method according to Claim 1, characterized by the use of B₃N₃H₆ (borazine) as the starting material.

7. Method according to any one of Claims 1 to 6, characterized in that the starting material used is a mixture of compounds which contain boron and nitrogen in the molecule.

8. Method according to any one of Claims 1 to 7, characterized by an addition of ammonia or nitrogen.

9. Method according to any one of Claims 1 to 8, characterized by the selection of the process parameters within the following ranges:
| | |
|---|---|
| deposition temperature | 200 - 450°C |
| process pressure | 1 - 100 mbar (0.1 - 10 kPa) |
| RF power | 100 - 800 W |
| Electrode separation | 0.3 - 1.5 cm |
| Carrier gas flow rate | 0 - 600 sccm of N₂ or He |
| N₂ or NH₃ flow rate | 0 - 500 sccm |
| Evaporator temperature | 25 - 120°C |

10. Method according to any one of claims 1 to 9, characterized in that mechanical, electrical or chemical properties of the deposited boron nitride layer are adjusted through the choice of starting material and/or suitable process parameters.

## Revendications

1. Procédé de fabrication d'une couche en nitrure de bore cubique micro-cristallin, par dépôt chimique en phase gazeuse dans un champ alternatif électromagnétique à une température de l'ordre de 200 à 450°C en utilisant une substance de départ excitée, qui contient du bore et de l'azote dans une molécule, une excitation inductive ou capacitive d'au moins la substance de départ dans une cathode creuse étant effectuée de manière que la substance de départ ne se décompose dans le champ alternatif électromagnétique qu'avec assistance thermique.

2. Procédé suivant la revendication 1, caractérisé par un composé à liaison bore-azote de coordination comme substance de départ.

3. Procédé suivant la revendication 1, caractérisé par un composé à liaison bore-azote covalente comme substance de départ.

4. Procédé suivant l'une des revendications 1 à 3, caractérisé par un composé ayant un rapport bore : azote < 1 comme substance de départ.

5. Procédé suivant l'une des revendications 1 à 4, caractérisé en ce que la substance de départ renferme au moins un groupe alcoyle, un groupe aryle, un groupe NH₂, de l'hydrogène et/ou un halogène.

6. Procédé suivant la revendication 1, caractérisé par l'utilisation de B₃N₃H₆ (borazine) comme substance de départ.

7. Procédé suivant l'une des revendications 1 à 6, caractérisé en ce qu'il consiste à utiliser comme de départ un mélange de composés qui renferme du bore et de l'azote dans la molécule.

8. Procédé suivant l'une des revendications 1 à 7, caractérisé par une addition d'ammoniac ou d'azote.

9. Procédé suivant l'une des revendications 1 à 8, caractérisé par le choix des paramètres du procédé dans les plages suivantes :
| | |
|---|---|
| Température de dépôt | 200 à 450°C |
| Pression du procédé | 1 à 100 mbar (0,1 à 10 kPa) |
| Puissance HF | 100 à 800 W |
| Distance entre les électrodes | 0,3 à 1,5 cm |
| Flux de gaz inerte | 0 à 600 cm³ dans les conditions normales de N₂ ou de He |
| Flux de N₂ et de NH₃ | 0 à 500 cm³ dans les conditions normales |
| Température de l'évaporateur | 25 à 120°C |

10. Procédé suivant l'une des revendications 1 à 9, caractérisé en ce qu'il consiste à régler les propriétés mécaniques, électriques ou chimiques de la couche de nitrure de bore déposée en choisissant la substance de départ et/ou les paramètres appropriés du procédé.
